# EUROPÄISCHE PATENTSCHRIFT

(11) **EP 0 651 113 B1**
(45) Veröffentlichungstag und Bekanntmachung des Hinweises auf die Patenterteilung: **03.01.1996**
(21) Anmeldenummer: 93112115.6
(22) Anmeldetag: 29.07.1993
(51) Int. Cl.: E04F 13/08

(54) **Vorrichtung zur Befestigung von plattenförmigen Fassadenelementen**
Fastening device for plate-like façade elements
Dispositif de fixation d'éléments de façade en forme de panneaux

(43) Veröffentlichungstag der Anmeldung: 03.05.1995
(73) Patentinhaber: Schuler, Jörg, Dipl.-Ing., D-40878 Ratingen (DE); Jatzlau, Ekkehard, Dipl.-Ing., D-40878 Ratingen (DE)
(72) Erfinder: Jatzlau, Ekkehard, D-40882 Ratingen (DE)
(74) Vertreter: Stenger, Watzke & Ring Patentanwälte

(56) Entgegenhaltungen:
- EP-A- 0 415 201
- DE-A- 3 632 764
- DE-A- 3 714 629
- DE-A- 3 735 490
- DE-U- 8 914 157
- DE-U- 9 208 252
- DE-U- 9 210 067

## Beschreibung

Die Erfindung betrifft eine Vorrichtung zur Befestigung von plattenförmigen Elementen, insbesondere zur Fassaden- oder Dachverkleidung an an einer Gebäudewand bzw. einem Dach befestigten Tragelementen mittels Befestigungselementen, die jeweils durch ein Außenteil und ein Innenteil gebildet sind, von denen das Außen- oder Innenteil mit einer Aufstandsfläche für den Rand eines plattenförmigen Elementes und das Außenteil jeweils mit einer Anlagefläche für dieses und ein benachbartes plattenförmiges Element versehen ist und die gemeinsam auf einem Schraubenbolzen angeordnet sind, der von dem jeweiligen Tragelement gehalten wird und unter Anpressung von Außenteil und Innenteil eine formschlüssige Verbindung zwischen Befestigungselement und Tragelement herstellt.

Befestigungsvorrichtungen der voranstehend beschriebenen Art sind aus der EP-A3-0 415 201 sowie der EP-Anmeldung 93 100 614.2 bekannt. Diese besitzen den Vorteil, daß mit einem Minimum an Teilen innerhalb kürzestmöglicher Zeit und mit geringem Aufwand Fassadenverkleidungen aus vorgefertigten plattenförmigen Fassadenelementen, wie Gläsern, Metallen, Natursteinen und sonstigen geeigneten Werkstoffen errichtet werden können, wobei die Befestigungsvorrichtungen auf einfache Weise einen Ausgleich sowohl der bauseitigen Maßabweichungen als auch der Fertigungstoleranzen der Fassadenelemente ermöglichen. Die Last der Fassadenelemente wird hierbei durch Formschluß auf die Gebäudewand übertragen, so daß die Schraubenbolzen der Befestigungselemente lediglich die Wind- und ggf. die Gerüstlasten aufzunehmen und für den konstruktiven Formschluß zu sorgen haben.

Mit diesen beiden bekannten Konstruktionen ist es jedoch nicht möglich, mehrscheibige Elemente zur Fassaden- oder Dachverkleidung mittels der Befestigungselemente an den Tragelementen zu befestigen, da die Scheiben fest zwischen Außenteil und Innenteil des Befestigungselementes verpreßt werden. Dieses Anpressen zwischen Innenteil und Außenteil des Befestigungselementes würde bei einem mehrscheibigen Element zu einem unzulässig hohen Anpreßdruck an der äußeren Scheibe führen, wodurch die Lebensdauer dieses mehrscheibigen Elementes nachhaltig negativ beeinflußt würde.

Der Erfindung liegt die **Aufgabe** zugrunde, die voranstehend geschilderten Nachteile der bekannten Konstruktionen zu vermeiden und diese derart weiterzubilden, daß auch mehrscheibige plattenförmige Elemente zur Fassaden- oder Dachverkleidung ohne die Gefahr der Beschädigung der Scheiben befestigt werden können.

Die **Lösung** dieser Aufgabenstellung durch die Erfindung ist dadurch gekennzeichnet, daß zur Befestigung von mindestens zweischeibigen Elementen jedes Befestigungselement mit einer zusätzlichen Aufstandsfläche für den gegenüber dem Rand der tragenden hintersten Scheibe zur Scheibenmitte versetzten Rand der äußersten Scheibe und mit zusätzlichen Anlageflächen für diese äußerste Scheibe und für die äußerste Scheibe des benachbarten Elementes versehen ist, wobei im montierten Zustand der Abstand der zusätzlichen Anlageflächen vom Innenteil größer ist als die Gesamtdicke des mindestens zweischeibigen Elementes.

Durch diese erfindungsgemäße Weiterbildung wird der Vorteil erreicht, daß das Einspannen der Fassadenelemente nur im Bereich der tragenden hintersten Scheibe erfolgt, die davorliegenden Scheiben jedoch aufgrund der separaten Aufstands- und Anlageflächen nur gegen Kippen und Sog gehalten werden. Die zusätzlichen Aufstandsflächen sind dabei so ausgestaltet, daß im montierten Zustand, d. h. wenn Außenteil und Innenteil des Befestigungselementes formschlüssig auf dem Schraubenbolzen angezogen sind, keine Preßkraft auf die äußerste Scheibe bzw. äußeren Scheiben ausgeübt wird.

Gemäß einer bevorzugten Ausführungsform der Erfindung sind die zusätzlichen Aufstands- und Anlageflächen am Außenteil des Befestigungselemente ausgebildet. Bei dieser Ausführungsform ist die dem Innenteil zugewandte Seite stufenförmig ausgebildet, wobei die tragende hintere Scheibe auf dem unteren, dem Schraubenbolzen näheren Absatz aufsteht und die äußerste Scheibe bzw. äußeren Scheiben auf dem oberen, zur Scheibenmitte der tragenden Scheibe hin versetzten Absatz aufstehen. Durch die Verwendung eines solchermaßen ausgebildeten Außenteiles ist die Montage mehrscheibiger Elemente mit einem Minimum an Teilen möglich.

Gemäß einem weiteren Merkmal der Erfindung sind die zusätzlichen Aufstands- und Anlageflächen an einem Zusatzteil ausgebildet, das formschlüssig am Außenteil des Befestigungselementes angeordnet ist und ebenfalls durch den Schraubenbolzen gehalten wird. Diese Weiterbildung bietet die Möglichkeit, Befestigungsvorrichtungen der eingangs beschriebenen bekannten Art innerhalb kürzestmöglicher Zeit und mit geringem Aufwand so umzurüsten, daß auch mindestens zweischeibige Elemente zur Fassaden- oder Dachverkleidung an den an der Gebäudewand befestigten Tragelementen zu befestigen sind.

Um diese Zusatzteile formschlüssig an dem Außenteil des Befestigungselementes anzuordnen, wird gemäß zweier alternativer Merkmale der Erfindung vorgeschlagen, daß das Zusatzteil entweder zwischen Außen- und Innenteil des Befestigungselementes oder auf der Außenseite des Außenteils des Befestigungselementes angeordnet ist. Diese Zusatzteile sind dabei erfindungsgemäß so ausgebildet, daß sie Abwinklungen zur formschlüssigen Anlage am Außenteil aufweisen. Durch die Abwinklungen stützt sich einerseits das Zusatzteil auf dem Außenteil ab und andererseits bilden diese Abwinklungen die zusätzlichen Aufstands- und Anlageflächen für die äußersten Scheiben.

Um Beschädigungen, wie beispielsweise Verkratzen, der Fassadenelemente durch den direkten Kontakt zwischen Fassadenelement und Befestigungselement zu vermeiden, wird gemäß einem weiteren Merkmal der Erfindung vorgeschlagen, daß zwischen den Aufstands- und/oder Anlageflächen für die hintersten und äußersten Scheiben der mindestens zweischeibigen Elemente elastische Zwischenlagen aus beispielsweise Kunststoff oder Gummi angeordnet sind.

Mit der Erfindung wird schließlich vorgeschlagen, daß die zweischeibigen Elemente als Mehrscheibengläser, Zweischeiben-Sicherheitsgläser, mit einem evakuierten Zwischenraum ausgebildete Dämmgläser oder als Photovoltaik-Elemente ausgebildet sind, wobei bei diesen Photovoltaik-Elementen zwischen der tragenden hinteren Scheibe und einer äußeren Abdeckscheibe eine Zwischenlage aus Kunststoff angeordnet ist, in die miteinander verbundenen Silicium-Zellen zur direkten Umwandlung der Lichtenergie in elektrische Energie eingebettet sind. Vorzugsweise besteht bei diesem Photovoltaik-Elementen die hintere tragende Scheibe aus Einscheiben-Sicherheitsglas und die äußere Abdeckscheibe aus Weißglas. Gerade bei der Verwendung dieser Photovoltaik-Elemente ist es wichtig, daß die äußere Scheibe nicht zwischen Innenteil und Außenteil des Befestigungselementes verpreßt wird, da eine Druck- bzw. Preßkraft auf die die Siliciun-Zellen tragende Kunststoffzwischenlage diese Kunststoffzwischenlage zwischen der hinteren und der äußeren Scheibe herauspressen und das Photovoltaik-Element zerstören könnte.

Auf der Zeichnung sind drei Ausführungsbeispiele der erfindungsgemäßen Befestigungsvorrichtung für plattenförmige Fassadenelemente dargestellt, und zwar zeigen:
- Fig. 1: eine perspektivische Darstellung vor der Montage einer Befestigungsvorrichtung mit einer ersten Ausführungsform eines Befestigungselementes,
- Fig. 2: einen senkrechten Schnitt im Bereich des Befestigungselementes gemäß der Schnittlinie II-II in Fig. 1,
- Fig. 3: eine Vorderansicht des Befestigungselementes gemäß Fig. 1 und 2,
- Fig. 4: einen senkrechten Schnitt durch eine zweite Ausführungsform eines Befestigungselementes und
- Fig. 5: einen senkrechten Schnitt durch eine dritte Ausführungsform eines Befestigungselementes.

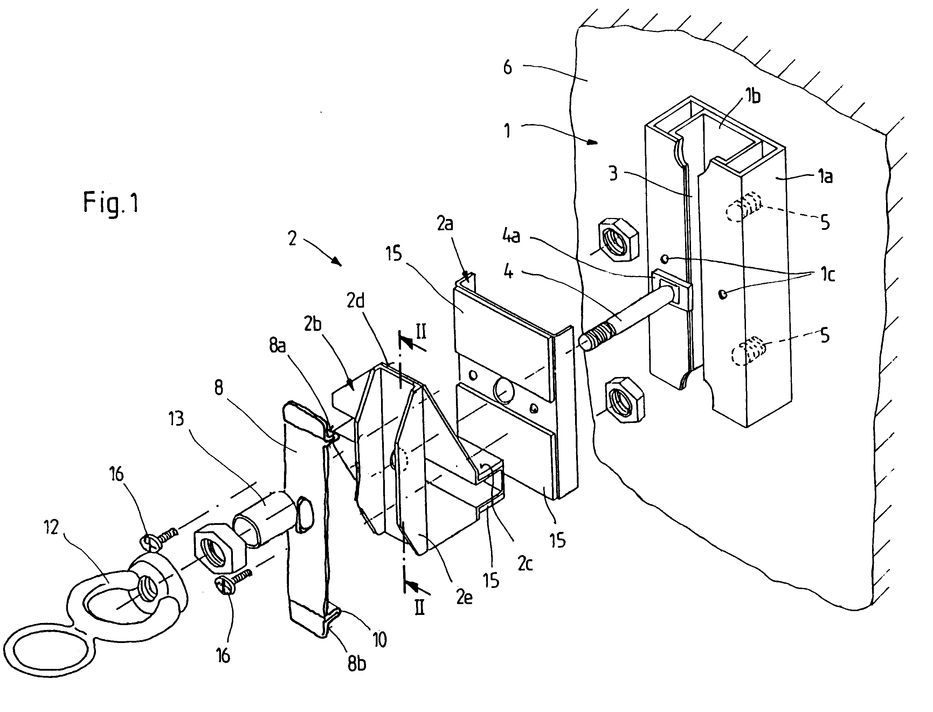

Wie aus Fig. 1 ersichtlich, besteht die Befestigungsvorrichtung im wesentlichen aus einem Tragelement 1 und einem Befestigungselement 2, wobei das Tragelement 1 beim Ausführungsbeispiel durch zwei ineinanderliegende C-Profile 1a und 1b gebildet wird, deren Stege aufeinanderliegen und deren abgewinkelte Schenkelenden eine durch einen Schlitz getrennte Führung 3 bilden. In dieser Führung 3 ist ein Schraubenbolzen 4 verschiebbar geführt, der beim Ausführungsbeispiel mit einem Hammerkopf 4a versehen und auf diese Weise unverdrehbar im Tragelement 1 geführt ist. Das Tragelement 1 ist mittels Schrauben 5 an einer Gebäudewand 6 befestigt.

Jedes Befestigungselement 2 besteht aus einem Innenteil 2a und einem Außenteil 2b, die gemeinsam auf dem Schraubenbolzen 4 angeordnet werden. Wie weiter aus Fig. 1 ersichtlich, ist jedes Außenteil 2b mit einer Aufstandsfläche 2c für ein plattenförmiges Element 7 versehen. Diese Aufstandsfläche 2c kann alternativ auch am Innenteil 2a ausgebildet sein. Beim Ausführungsbeispiel wird die Aufstandsfläche 2c am Außenteil 2b durch mehrfaches Verkröpfen des Außenteiles 2b geschaffen. Die Verkröpfung wird hierbei mit einer Tiefe ausgeführt, die der Dicke des jeweils zu befestigenden Elementes 7 im Bereich seiner Aufstandskante entspricht. Die Höhe der Verkröpfung entspricht dem Abstand der jeweils benachbarten Elemente 7, d. h. der zwischen benachbarten Elementen 7 gebildeten Fuge.

Oberhalb und unterhalb der Aufstandsfläche 2c bildet jedes Außenteil 2b eine Anlagefläche 2d für das obere und für das untere Element 7. Während die Last des jeweils auf dem Außenteil 2b aufstehenden plattenförmigen Elementes 7 über die Aufstandsfläche 2c aufgenommen wird, tragen die Anlageflächen 2d die auf die plattenförmigen Elemente 7 ausgeübten Windkräfte ab, und zwar über den Schraubenbolzen 4 in die Tragelemente 1, die wie beschrieben an der Gebäudewand 6 befestigt sind.

Zur Aufnahme mindestens zweischeibiger, im Ausführungsbeispiel dreischeibiger Elemente 7 ist bei dem in Fig. 1 dargestellten Ausführungsbeispiel einer Befestigungsvorrichtung auf der Außenseite des Außenteiles 2b des Befestigungselementes 2 ein Zusatzteil 8 angeordnet, welches eine zusätzliche Aufstandsfläche 8a sowie zusätzliche Anlageflächen 8b zum Aufstellen und Halten der äußersten Scheibe 9 eines dreischeibigen Elementes 7 aufweist.

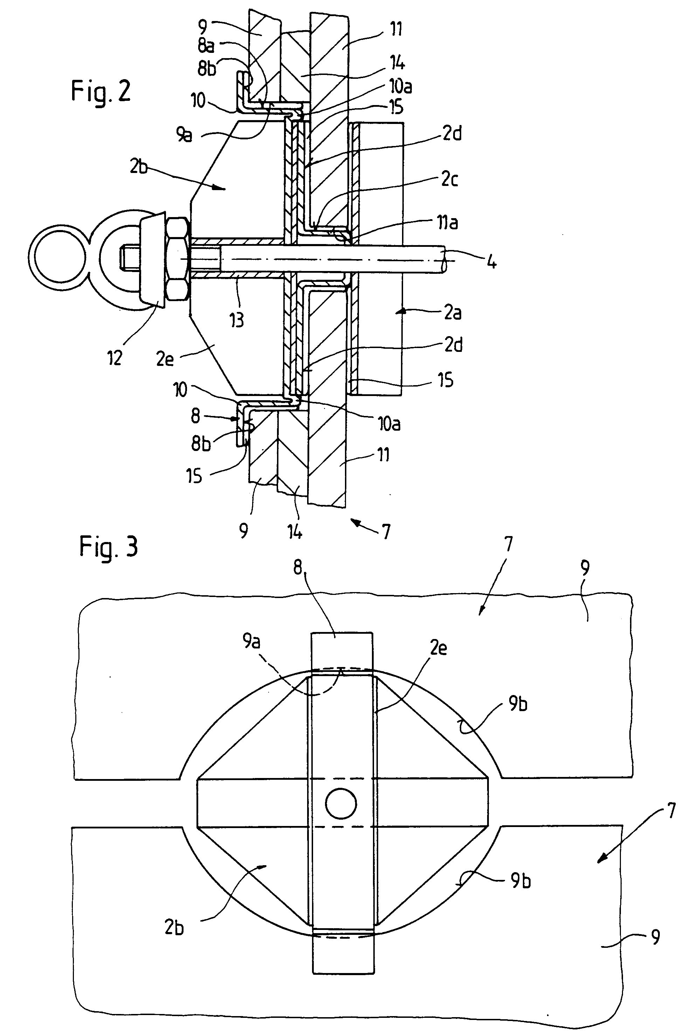

Wie aus Fig. 2 ersichtlich, ist das Zusatzteil 8 durch mehrfaches Verkröpfen so ausgebildet, daß Abwinklungen 10 im fertigmontierten Zustand die formschlüssige Verbindung des Zusatzteiles 8 mit dem Außenteil 2b garantieren. Bei dem in Fig. 1 bis 3 dargestellten ersten Ausführungsbeispiel eines Befestigungselementes 2 ist das Zusatzteil 8 auf der Außenseite des Außenteiles 2b innerhalb eines U-förmigen Verstärkungssteges 2e angeordnet und liegt mit durch zweifaches Abwinkeln gebildeten Falten 10a formschlüssig an dem oberen bzw. unteren Rand des Außenteils 2b an. Bei einer abgewandelten Ausführung kann die untere Falte 10a entfallen, weil nur über die obere Falte 10a Lasten abgetragen werden, wogegen unten nur Windkräfte von der Seite her wirken. Durch den Wegfall der unteren Falte 10a wird Luftraum zur Aufnahme von Maßabweichungen bei der Scheibenfertigung gewonnen.

Bei dem in Fig. 2 dargestellten fertigmontierten Befestigungselement 2 ist zu erkennen, daß eine hinterste Scheibe 11 eines dreischeibigen Elementes 7 als tragende Scheibe zwischen dem Innenteil 2a und dem Außenteil 2b des Befestigungselementes 2 verpreßt ist, wenn eine beispielsweise als Gerüstöse ausgebildete Ringösenmutter 12 dafür sorgt, daß das aus Außenteil 2b und Innenteil 2a bestehende Befestigungselement 2 an das Tragelement 1 angepreßt wird. Eine glattwandige Hülse 13 wird dabei als Abstandshülse verwendet.

Im dargestellten Zustand ist der Abstand der zusätzlichen Anlageflächen 8b vom Innenteil 2a größer als die Gesamtdicke des dreischeibigen Elementes 7. Durch diesen größeren Abstand wird garantiert, daß die äußerste Scheibe 9 keine Preßkräfte aufnimmt. Dies ist insbesondere wichtig, wenn das dreischeibige Element 7 als Photovoltaik-Element ausgebildet ist, wobei zwischen der hintersten Scheibe 11 und der äußersten, als Abdeckung dienenden Scheibe 9 eine Kunststoffzwischenlage 14 angeordnet ist, in der die miteinander verbundenen Silicium-Zellen zur direkten Umwandlung von Licht in elektrische Energie eingebettet sind.

Um Beschädigungen der Elemente 7 durch die metallenen Bauteile des Befestigungselementes 2 zu verhindern, sind die Aufstandsflächen 2c, 8a und Anlageflächen 2d, 8b auf denen bzw. an denen die Ränder 9a und 11a der äußersten Scheibe 9 bzw. der hintersten Scheibe 11 liegen, mit einer elastischen Zwischenlage 15 versehen, welche vorzugsweise aus Kunststoff oder Gummi besteht.

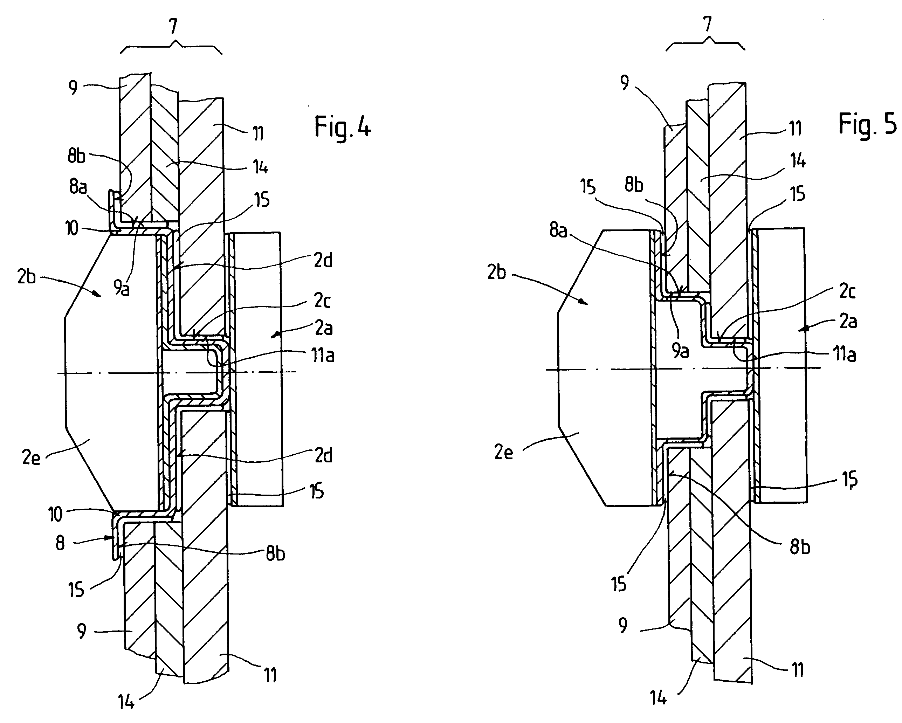

Gemäß der in Fig. 4 dargestellten zweiten Ausführungsform eines Befestigungselementes 2 ist das Zusatzteil 8 auf der Innenseite des Außenteiles 2b des Befestigungselementes 2 angeordnet. Dabei ist das Zusatzteil 8 durch mehrfaches Abkröpfen so ausgebildet, daß die gebildeten Abwinklungen 10 zum einen formschlüssig an der inneren Oberfläche des Außenteils 2b anliegen und andererseits die zusätzlichen Aufstandsflächen 8a sowie zusätzlichen Anlageflächen 8b bilden.

Die in Fig. 5 dargestellte dritte Ausführungsform eines Befestigungselementes 2 zeichnet sich dadurch aus, daß sie keines Zusatzteiles 8 bedarf, da die zusätzlichen Aufstandsflächen 8a sowie die zusätzlichen Anlageflächen 8b auf der Innenseite des Außenteiles 2b ausgebildet sind. Die Innenseite des Außenteils 2b des Befestigungselementes 2 ist dabei stufenförmig so ausgebildet, daß ein unterer Absatz die Aufstandsfläche 2c und ein oberer Absatz die zusätzliche Aufstandsfläche 8a für die äußerste Scheibe 9 bildet. Die Tiefe des obersten Absatzes ist dabei wiederum so ausgebildet, daß im fertigmontierten Zustand des Befestigungselementes 2 nur die hinterste Scheibe 11 zwischen Außenteil 2b und Innenteil 2a (unter Zwischenfügen einer Zwischenlage 15) verpreßt wird, jedoch die äußerste Scheibe 9 durch die zusätzliche Anlagefläche 8b nur gegen Kippen gesichert wird, nicht jedoch eingespannt wird.

Um die aus dem Gewicht der Elemente 7 herrührenden Traglasten durch Formschluß in das Tragelement 1 einzuleiten, werden Schrauben 16 verwendet, die in Fig. 1 zu erkennen sind. Diese vorzugsweise selbstschneidend ausgeführten Schrauben 16 werden in Löcher 1c eingeschraubt, die in das Tragelement 1 gebohrt werden, nachdem das Befestigungselement 2 durch Verschieben des Schraubenbolzens 4 in der Führung 3 ausgerichtet worden ist. Die von den auf den Aufstandsflächen 2c und 8a aufstehenden Elementen 7 herrührenden Traglasten werden somit formschlüssig über die auf Scherung belasteten Schrauben 16 in das Tragelement 1 eingeleitet.

Aus dem Ausführungsbeispiel nach Fig. 3 geht hervor, daß der Versatz des mit der zusätzlichen Aufstandsfläche 8a zusammenwirkenden Randes 9a der äußersten Scheibe 9 gegenüber dem auf der Aufstandsfläche 2c aufstehenden Rand 11a der hintersten Scheibe 11 nicht nur durch einen entsprechenden Versatz des kompletten unteren Randes der Scheiben 9 und 11 erzielt werden kann, sondern durch in der äußersten Scheibe 9 ausgebildete halbkreisförmige Aussparungen 9b. Diese Aussparungen 9b sorgen dafür, daß die Außenteile 2b auf die Innenteile 2a aufgesetzt und mittels des Schraubenbolzens 4 verspannt werden können, ohne daß sich eine unerwünschte Einspannung der äußersten Scheibe 9 und Zwischenlagen 14 ergibt.

### Bezugszeichenliste :

- 1: Tragelement
- 1a: C-Profil
- 1b: C-Profil
- 1c: Loch
- 2: Befestigungselement
- 2a: Innenteil
- 2b: Außenteil
- 2c: Aufstandsfläche
- 2d: Anlagefläche
- 2e: Verstärkungssteg
- 3: Führung
- 4: Schraubenbolzen
- 4a: Hammerkopf
- 5: Schraube
- 6: Gebäudewand
- 7: Element
- 8: Zusatzteil
- 8a: Aufstandsfläche
- 8b: Anlagefläche
- 9: Scheibe (äußerste)
- 9a: Rand
- 9b: Aussparung
- 10: Abwinklung
- 10a: Falte
- 11: Scheibe (hinterste)
- 11a: Rand
- 12: Ringösenmutter
- 13: Abstandshülse
- 14: Zwischenlage (Kunststoff)
- 15: Zwischenlage
- 16: Schraube

## Patentansprüche

1. Vorrichtung zur Befestigung von plattenförmigen Elementen (7), insbesondere zur Fassaden- oder Dachverkleidung, an an einer Gebäudewand (6) bzw. einem Dach befestigten Tragelementen (1) mittels Befestigungselementen (2), die jeweils durch ein Außenteil (2b) und ein Innenteil (2a) gebildet sind, von denen das Außen- oder Innenteil (2b, 2a) mit einer Aufstandsfläche (2c) für den Rand eines plattenförmigen Elementes (7) und das Außenteil (2b) jeweils mit einer Anlagefläche (2d) für dieses und ein benachbartes plattenförmiges Element (7) versehen ist und die gemeinsam auf einem Schraubenbolzen (4) angeordnet sind, der von dem jeweiligen Tragelement (1) gehalten wird und unter Anpressung von Außenteil (2b) und Innenteil (2a) eine formschlüssige Verbindung zwischen Befestigungselement (2) und Tragelement (1) herstellt,
**dadurch gekennzeichnet,**
daß zur Befestigung von mindestens zweischeibigen Elementen (7) jedes Befestigungselement (2) mit einer zusätzlichen Aufstandsfläche (8a) für den gegenüber dem Rand (11a) der tragenden hintersten Scheibe (11) zur Scheibenmitte versetzten Rand (9a) der äußersten Scheibe (9) und mit zusätzlichen Anlageflächen (8b) für diese äußerste Scheibe (9) und für die äußerste Scheibe (9) des benachbarten Elementes (7) versehen ist, wobei im montierten Zustand der Abstand der zusätzlichen Anlageflächen (8b) vom Innenteil (2a) größer ist als die Gesamtdicke des mindestens zweischeibigen Elementes (7).

2. Vorrichtung nach Anspruch 1, dadurch gekennzeichnet, daß die zusätzlichen Aufstands- und Anlageflächen (8a, 8b) am Außenteil (2b) des Befestigungselementes (2) ausgebildet sind.

3. Vorrichtung nach Anspruch 1, dadurch gekennzeichnet, daß die zusätzlichen Aufstands- und Anlageflächen (8a, 8b) an einem Zusatzteil (8) ausgebildet sind, das formschlüssig am Außenteil (2b) des Befestigungselementes (2) angeordnet und durch den Schraubenbolzen (4) gehalten ist.

4. Vorrichtung nach Anspruch 3, dadurch gekennzeichnet, daß das Zusatzteil (8) zwischen Außen- und Innenteil (2b, 2a) des Befestigungselementes (2) angeordnet ist.

5. Vorrichtung nach Anspruch 3, dadurch gekennzeichnet, daß das Zusatzteil (8) auf der Außenseite des Außenteiles (2b) des Befestigungselementes (2) angeordnet ist.

6. Vorrichtung nach Anspruch 4 oder 5, dadurch gekennzeichnet, daß das Zusatzteil (8) mit Abwinklungen (10) zur formschlüssigen Anlage am Außenteil (2b) des Befestigungselementes (2) ausgebildet ist.

7. Vorrichtung nach mindestens einem der Ansprüche 1 bis 6, dadurch gekennzeichnet, daß zwischen den Aufstands- und/oder Anlageflächen (2c, 8a, 2d, 8b) für die hintersten und äußersten Scheiben (11, 9) des mindestens zweischeibigen Elementes (7) elastische Zwischenlagen (15) angeordnet sind.

8. Vorrichtung nach mindestens einem der Ansprüche 1 bis 7, dadurch gekennzeichnet, daß die zweischeibigen Elemente (7) als Mehrscheibengläser, Zweischeiben-Sicherheitsgläser, mit einem evakuierten Zwischenraum ausgebildete Dämmgläser oder als Photovoltaik-Elemente ausgebildet sind, die zwischen einer tragenden hinteren Scheibe (11), vorzugsweise aus Einscheiben-Sicherheitsglas, und einer äußeren Abdeckscheibe (9), vorzugsweise aus Weißglas, eine Zwischenlage (14) aus Kunststoff aufweisen, in die miteinander verbundene Silicium-Zellen zur direkten Umwandlung von Lichtenergie in elektrische Energie eingebettet sind.

## Claims

1. Device for fastening panel-like elements (7), in particular for facade or roof cladding, on load-bearing elements (1), fastened on a building wall (6) or on a roof, by means of fastening elements (2) which are each formed by an outer part (2b) and an inner part (2a), of which the outer or inner part (2b, 2a) is provided with a supporting surface (2c) for the border of a panel-like element (7) and the outer part (2b) is provided in each case with a bearing surface (2d) for said panel-like element (7) and an adjacent panel-like element (7), and both the outer part (2b) and the inner part (2a) being arranged jointly on a screw-bolt (4) which is retained by the respective load-bearing element (1) and, with the outer part (2b) and inner part (2a) being pressed against one another, produces a positively locking connection between the fastening element (2) and load-bearing element (1), characterized in that, in order to fasten at least two-pane elements (7), each fastening element (2) is provided with an additional supporting surface (8a) for the border (9a) which belongs to the outermost pane (9) and is offset towards-the pane centre with respect to the border (11a) of the load-bearing rearmost pane (11), and with additional bearing surfaces (8b) for said outermost pane (9) and for the outermost pane (9) of the adjacent element (7), the distance of the additional bearing surfaces (8b) from the inner part (2a), in the mounted state, being greater than the overall thickness of the at least two-pane element (7).

2. Device according to Claim 1, characterized in that the additional supporting and bearing surfaces (8a, 8b) are formed on the outer part (2b) of the fastening element (2).

3. Device according to Claim 1, characterized in that the additional supporting and bearing surfaces (8a, 8b) are formed on an additional part (8), which is arranged in a positively locking manner on the outer part (2b) of the fastening element (2) and is retained by the screw-bolt (4).

4. Device according to Claim 3, characterized in that the additional part (8) is arranged between the outer and inner parts (2b, 2a) of the fastening element (2).

5. Device according to Claim 3, characterized in that the additional part (8) is arranged on the outer side of the outer part (2b) of the fastening element (2).

6. Device according to Claims 4 or 5, characterized in that the additional part (8) is designed with angled-off portions (10) in order that it can bear in a positively locking manner against the outer part (2b) of the fastening element (2).

7. Device according to at least one of Claims 1 to 6, characterized in that elastic intermediate layers (15) are arranged between the supporting and/or bearing surfaces (2c, 8a, 2d, 8b) for the rearmost and outermost panes (11, 9) of the at least two-pane element (7).

8. Device according to at least one of Claims 1 to 7, characterized in that the two-pane elements (7) are designed as laminated-glass units, two-pane safety-glass units, insulating-glass units designed with an evacuated interspace, or as photovoltaic elements which exhibit a plastic intermediate layer (14) between a load-bearing rear pane (11), preferably made of toughened safety glass, and an outer covering pane (9), preferably made of flint glass, into which intermediate layer there are embedded interconnected silicon cells for the direct conversion of light energy into electric energy.

## Revendications

1. Dispositif de fixation d'éléments en forme de plaques (7), en particulier pour garnir des façades ou des toitures, sur des éléments porteurs (1) fixés à un mur (6) de bâtiment ou à une toiture, au moyen d'éléments de fixation (2) qui sont formés chacun d'une partie extérieure (2b) et d'une partie intérieure (2a), dont la partie extérieure ou intérieure (2b, 2a) comporte une surface d'appui horizontale (2c) pour le bord d'un élément en forme de plaque (7) et la partie extérieure correspondante (2b) comporte une surface d'appui verticale (2d) pour ce même élément et pour un élément en forme de plaque (7) voisin, et qui sont disposés conjointement sur un boulon fileté (4) qui est retenu par l'élément porteur correspondant (1) et qui, en serrant la partie extérieure (2b) et la partie intérieure (2a) l'une contre l'autre, crée une liaison par conjugaison de formes entre l'élément de fixation (2) et l'élément porteur (1), caractérisé en ce que, pour fixer des éléments à au moins deux vitres (7), chaque élément de fixation (2) comporte une surface d'appui horizontale supplémentaire (8a) pour le bord (9a) de la vitre extérieure extrême (9) décalé vers le centre de la vitre par rapport au bord (11a) de la vitre porteuse (11) située le plus à l'arrière, et comporte des surfaces d'appui verticales supplémentaires (8b) pour cette vitre extérieure extrême (9) et pour la vitre extérieure extrême (9) de l'élément voisin (7), l'écartement entre les surfaces d'appui verticales supplémentaires (8b) et la partie intérieure (2a) étant, en position montée, supérieur à l'épaisseur totale de l'élément à au moins deux vitres (7).

2. Dispositif selon la revendication 1, caractérisé en ce que les surfaces d'appui horizontales et verticales supplémentaires (8a, 8b) sont réalisées sur la partie extérieure (2b) de l'élément de fixation (2).

3. Dispositif selon la revendication 1, caractérisé en ce que les surfaces d'appui horizontales et verticales supplémentaires (8a, 8b) sont réalisées sur une partie supplémentaire (8) qui est disposée par conjugaison de formes contre la partie extérieure (2b) de l'élément de fixation (2) et est également maintenue par le boulon fileté (4).

4. Dispositif selon la revendication 3, caractérisé en ce que la partie supplémentaire (8) est placée entre les parties extérieure et intérieure (2b, 2a) de l'élément de fixation (2).

5. Dispositif selon la revendication 3, caractérisé en ce que la partie supplémentaire (8) est placée sur la face extérieure de la partie extérieure (2b) de l'élément de fixation (2).

6. Dispositif selon la revendication 4 ou 5, caractérisé en ce que la partie supplémentaire (8) est conçue avec des portions coudées (10) permettant de l'appliquer par conjugaison de formes contre la partie extérieure (2b) de l'élément de fixation (2).

7. Dispositif selon au moins l'une des revendications 1 à 6, caractérisé en ce que des garnitures intermédiaires élastiques (15) sont disposées entre les surfaces d'appui horizontales et/ou verticales (2c, 8a, 2d, 8b) destinées aux vitres arrière extrême et extérieure extrême (11, 9) de l'élément (7) à au moins deux vitres.

8. Dispositif selon au moins l'une des revendications 1 à 7, caractérisé en ce que les éléments à deux vitres (7) sont conçus sous la forme de verres à plusieurs vitres, de verres de sécurité à deux vitres, de verres isolants séparés par un interstice où est réalisé un vide partiel, ou d'éléments photovoltaïques qui, entre la vitre porteuse arrière (11), de préférence en verre de sécurité à une vitre, et une vitre de recouvrement extérieure (9), de préférence en verre blanc, comportent une garniture intermédiaire (14) en matière synthétique dans laquelle des cellules au silicium reliées entre elles sont noyées pour convertir directement l'énergie lumineuse en énergie électrique.
